# EUROPEAN PATENT APPLICATION

(11) **EP 4 793 981 A1**
(43) Date of publication of application: **19.08.2026**
(21) Application number: 25223082.6
(22) Date of filing: 12.12.2025
(51) Int. Cl.: H01H 9/02, B66F 11/04, B66F 17/00, H05K 5/02, B66C 13/40

(54) **INSULATING LOWER CONTROLS DEVICE**

(30) Priority: 23.12.2024 US 202418999068
(71) Applicant: Altec Industries, Inc., Birmingham, AL 35242 (US)
(72) Inventor: CLAUSS, Bradford, Birmingham (US); HALL, Bryan, Birmingham (US)
(74) Representative: Finlayson, Scott Henry

(57) **Abstract**

Systems, methods, devices, and assemblies for electrically insulating lower controls of a low voltage aerial device. The lower controls may include two or more electrically insulating components working concurrently to provide electrically insulating capabilities to electrically isolate one or more electrical cables or other electrically conductive components associated with the lower controls. For example, one or more electrical cables may communicate with an upper portion of the low voltage aerial device, such that the electrically insulating components break an electrical path to ground from the upper portion of the low voltage aerial device.

## Description

### BACKGROUND

### 1. FIELD

Embodiments of the present disclosure relate to control devices of aerial devices. More specifically, embodiments of the present disclosure relate to insulating lower control devices for low voltage aerial device.

### 2. RELATED ART

Aerial devices include two distinct types of aerial devices rated for respective voltage applications: high voltage aerial devices rated for high voltage applications, which typically include at least two distinct sections electrically isolated from one another across a dielectric gap; and low voltage aerial devices, which typically do not include an electrically isolated dielectric gap. For example, low voltage aerial devices may be used to provide installation and maintenance on relatively lower voltage utility lines, such as telephone lines, among other example operations, as opposed to high voltage lines such as those associated with power distribution, for example. However, it may still be desirable to electrically isolate controls devices of the low voltage aerial device, such as, lower controls operated by personnel at ground level.

Traditional lower control boxes for aerial devices rated for low voltage applications typically include a number of user controls disposed on a metal box, which is electrically conductive. Accordingly, in the case of inadvertent contact with a high voltage line, an electrical path to ground may be established from an upper portion of the low voltage aerial device through the conductive control box and electronics and wiring disposed therein.

### SUMMARY

Embodiments of the present disclosure solve the above-mentioned problems by providing systems, methods, devices, and assemblies relating to electrically insulating lower controls for a low voltage aerial device. The insulating lower controls may include two or more electrically insulating components working concurrently to provide electrically insulating capabilities to electrically isolate one or more electrical cables associated with the lower controls. For example, one or more electrical cables may communicate with an upper portion of the low voltage aerial device, such that the electrically insulating components break an electrical path to ground from the upper portion of the low voltage aerial device.

In some aspects, the techniques described herein relate to a user control device for a low voltage aerial device, the user control device disposed at a lower portion of the low voltage aerial device and including: an electrically insulating enclosure encapsulating an internal portion of the user control device; a plurality of user controls disposed on the electrically insulating enclosure with at least a portion of each user control of the plurality of user controls external to the electrically insulating enclosure, the plurality of user controls operable to control the low voltage aerial device from the lower portion responsive to user inputs from an operator standing on a ground surface near the lower portion; a plurality of electrical cables coupled to the plurality of user controls within the internal portion of the user control device, the plurality of electrical cables operable to transmit control signals associated with the plurality of user controls to an upper portion of the low voltage aerial device; and at least one electrically insulating cable cover disposed around the plurality of electrical cables, wherein the electrically insulating enclosure and the at least one electrically insulating cable cover prevent an electrical path to ground through the user control device from the upper portion of the low voltage aerial device.

In some aspects, the techniques described herein relate to a user control device for a low voltage aerial device, the user control device disposed at a lower portion of the low voltage aerial device and including: an electrically insulating enclosure encapsulating an internal portion of the user control device; at least one user control disposed on the electrically insulating enclosure with at least a portion of the at least one user control external to the electrically insulating enclosure, the at least one user control operable to control the low voltage aerial device from the lower portion responsive to user inputs from an operator standing on a ground surface near the lower portion; at least one electrical cable coupled to the at least one user control within the internal portion of the user control device, the at least one electrical cable operable to transmit control signals associated with the at least one user control to an upper portion of the low voltage aerial device; and at least one electrically insulating cable cover disposed around the at least one electrical cable, wherein an end portion of the at least one electrically insulating cable cover extends into the electrically insulating enclosure.

In some aspects, the techniques described herein relate to a lower controls system for a low voltage aerial device, the lower controls system including: a lower controls device operable to be held by an operator standing on a ground surface to control a portion of the low voltage aerial device, the lower controls device including: an electrically insulating enclosure encapsulating an internal portion of the lower controls device; a plurality of user controls disposed on the electrically insulating enclosure with at least a portion of each user control of the plurality of user controls external to the electrically insulating enclosure, the plurality of user controls operable to receive user inputs from the operator; at least one electrical cable coupled to the lower controls device, the at least one electrical cable operable to transmit control signals associated with the plurality of user controls to the low voltage aerial device; and at least one electrically insulating cable cover disposed around the at least one electrical cable, wherein the electrically insulating enclosure and the at least one electrically insulating cable cover prevent an electrical path to ground through the lower controls device.

This summary is provided to introduce a selection of concepts in a simplified form that are further described below in the detailed description. This summary is not intended to identify key features or essential features of the claimed subject matter, nor is it intended to be used to limit the scope of the claimed subject matter. Other aspects and advantages of the present disclosure will be apparent from the following detailed description of the embodiments and the accompanying drawing figures.

### BRIEF DESCRIPTION OF THE DRAWING FIGURES

Embodiments of the present disclosure are described in detail below with reference to the attached drawing figures, wherein:
FIG. 1 illustrates an exemplary aerial device relating to some embodiments of the present disclosure;
FIG. 2 illustrates a lower portion of an aerial device relating to some embodiments of the present disclosure;
FIG. 3 illustrates an exemplary lower controls device relating to some embodiments of the present disclosure;
FIG. 4 illustrates a lower controls device with the external cover portions removed relating to some embodiments of the present disclosure;
FIG. 5 illustrates an exemplary switch relating to some embodiments of the present disclosure; and
FIG. 6 illustrates an exemplary internal portion of a lower controls device relating to some embodiments of the present disclosure.

The drawing figures do not limit the present disclosure to the specific embodiments disclosed and described herein. The drawings are not necessarily to scale, emphasis instead being placed upon clearly illustrating the principles of the present disclosure.

### DETAILED DESCRIPTION

The following detailed description references the accompanying drawings that illustrate specific embodiments in which the present disclosure can be practiced. The embodiments are intended to describe aspects of the present disclosure in sufficient detail to enable those skilled in the art to practice the present disclosure. Other embodiments can be utilized and changes can be made without departing from the scope of the present disclosure. The following detailed description is, therefore, not to be taken in a limiting sense. The scope of the present disclosure is defined only by the appended claims, along with the full scope of equivalents to which such claims are entitled.

In this description, references to "one embodiment," "an embodiment," or "embodiments" mean that the feature or features being referred to are included in at least one embodiment of the technology. Separate references to "one embodiment," "an embodiment," or "embodiments" in this description do not necessarily refer to the same embodiment and are also not mutually exclusive unless so stated and/or except as will be readily apparent to those skilled in the art from the description. For example, a feature, structure, act, etc. described in one embodiment may also be included in other embodiments, but is not necessarily included. Thus, the technology can include a variety of combinations and/or integrations of the embodiments described herein.

Embodiments of the present disclosure contemplate a lower controls device and lower controls system for manual control of a low voltage aerial device from an operator standing on the ground. The lower controls device may include one or more electrically conductive components disposed therein with electrically insulating components disposed external to an internal portion of the lower controls device to electrically isolate the electrically conductive components. The electrically insulating components described herein may be used to prevent a path to ground associated with the lower controls device at least to a predetermined voltage level.

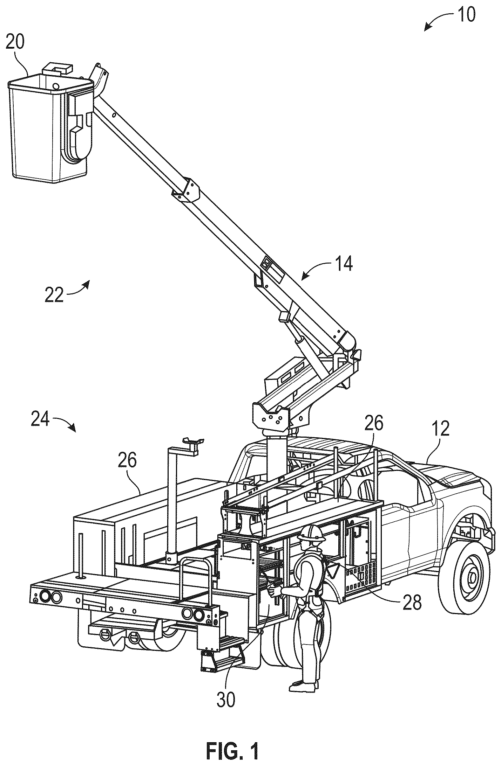

FIG. 1 illustrates an exemplary aerial device 10 relating to some embodiments of the present disclosure. Aerial device 10 may include or be attached to a base portion, such as, a utility vehicle 12, as shown. In some embodiments, aerial device 10 comprises boom assembly 14, for example, with an upper boom section and a lower boom section, as shown. In some embodiments, the boom assembly 14 may include any combination of telescoping and articulating boom sections.

In some embodiments, the aerial device 10 includes an upper portion 22 and a lower portion 24. For example, the upper portion 22 may include the platform 20 and at least the upper section of the boom assembly 14 and the lower portion 24 may include the base portion such as the utility vehicle 12. In some embodiments, the aerial device 10 comprises a low voltage aerial device that does not include an electrically isolating dielectric gap. As such, in some such embodiments, the upper portion 22 and the lower portion 24 may not be fully electrically isolated from one another such that an electrical path to ground may travel through a component of the upper portion 22 through the boom assembly 14 to the lower portion 24 of the low voltage aerial device 10.

Low voltage aerial device or low voltage insulating aerial device, as referred to herein, may refer to utility equipment rated for low voltage applications, such as, for example, the Category E aerial booms described in the ANSI standard, (ANSI, A92.2, 2021), rated for voltages of 20 kV, 5 kV, 1 kV, and below. In some embodiments, a low voltage aerial device is an aerial device rated for low voltage applications that may provide no electrical insulation or at least partial electrical insulation, but does not include a dielectric insulating gap, such as is the case for insulating aerial devices rated for high voltage applications. In some embodiments, low voltage aerial device may refer to either of a low voltage insulating aerial device or a non-insulating aerial device. However, it should be understood that other types and forms of low voltage aerial devices are also contemplated. For example, in some embodiments, similar solutions are contemplated for non-vehicle mounted aerial devices and assemblies.

In some embodiments, low voltage aerial devices, as referred to herein, include aerial devices rated for voltages of less than 20 kV. Further, in some embodiments, low voltage aerial devices, as referred to herein, include aerial devices rated for voltages of less than 15 kV. Further still, in some embodiments, low voltage aerial devices, as referred to herein, include aerial devices rated for voltages of less than 10 kV or less than 5 kV. In some embodiments, low voltage aerial devices includes aerial devices rated for around 1 kV.

The low voltage aerial device 10, as described herein may include one or more electrically conductive structures. For example, in some embodiments, the boom sections of the boom assembly 14 may comprise an electrically conductive metal, such as steel, or another electrically conductive material. As such, even though the low voltage aerial device 10 is designed for low voltage applications, such as telephone lines, there is a risk of contact with higher voltage lines such as those associated with power distribution, which are typically formed of electrically insulating materials such as, fiberglass. Accordingly, because components of the boom assembly 14 are electrically conductive at least to an extent, in the case of inadvertent contact with a high voltage line, there is risk of electrical shock associated with an electrical path to ground from the high voltage line through the low voltage aerial device 10. For example, there is potential for electrical current associated with a high voltage line flowing through the electrically conductive structures of the boom assembly 14, through the vehicle chassis of the utility vehicle 12, and through one or more electrical components of a control device of the aerial device 10.

In some embodiments, the utility vehicle 12 includes one or more side packs 26. For example, a side pack 26 may be disposed on each side of the bed of the utility vehicle 12, as shown. In some embodiments, the side packs 26 include one or more storage compartments for storing objects and tools associated with the aerial device 10. For example, each side pack 26 may include any combination of shelves, drawers, and alcoves for storing equipment and materials associated with operation of the aerial device 10.

In some embodiments, the aerial device 10 is controlled by an operator 28 standing on the ground near the lower portion 24. For example, an operator 28 may manually control operation of the aerial device 10 while standing near the side pack 26 of the utility vehicle 12. In some embodiments, the aerial device 10 includes a lower controls device 30 operable to allow the operator 28 to control operations of the aerial device 10 from the lower portion 24 or near the lower portion 24, as shown. For example, in some embodiments, the lower controls device 30 is coupled to the side pack 26. Alternatively, or additionally, embodiments are contemplated in which the lower controls device 30 is coupled to another portion of the lower portion 24 of the aerial device 10, such as, for example, at a turntable associated with the boom assembly 14, on the bed of the utility vehicle 12, or near the cab of the utility vehicle 12.

In some embodiments, the lower controls device 30 is configured to be held by the operator 28, while in use. For example, the operator 28 may stand on a ground surface proximate to the base of the aerial device 10 while holding the lower controls device 30 in hand, as shown. As will be described in further detail below, in some embodiments, the lower controls device 30 includes one or more electrically conductive components disposed therein, such as electrical wires, electrical chips, as well as other electrically conductive components and devices not explicitly described herein. In some embodiments, the lower controls device 30 also includes one or more electrically insulating components to electrically isolate the one or more electrically conductive components. For example, the one or more electrically insulating components may shield the conductive components and prevent an electrical path to ground through the lower controls device 30. In some embodiments, the lower controls device 30 comprises a plurality of electrically insulating components that act collectively to prevent electrical shock and path to ground.

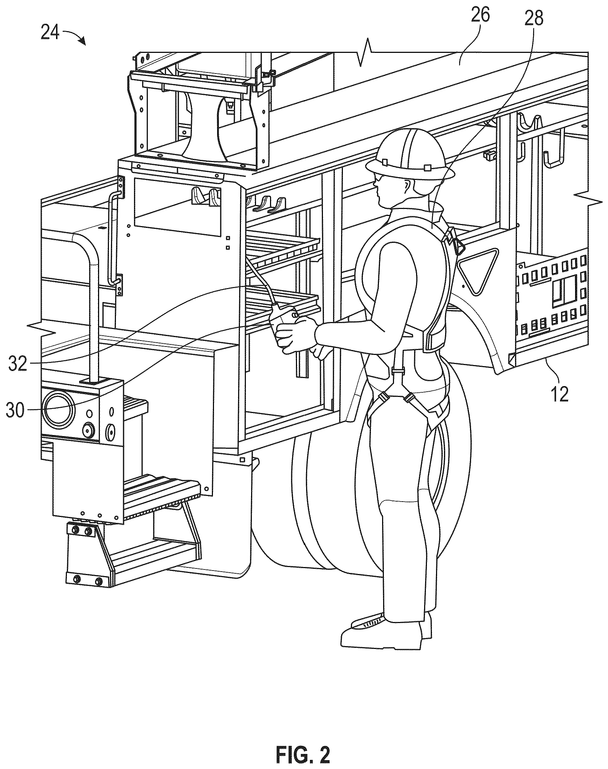

Turning now to FIG. 2, the lower portion 24 of the aerial device 10 is shown in greater detail relating to some embodiments of the present disclosure. As described above, the lower controls device 30 may be coupled to the side pack 26 such as within a storage compartment of the side pack 26. In some embodiments, the lower controls device 30 includes at least one cable 32, as shown. In some embodiments, the at least one cable 32 comprises a control cable operable to transmit control signals from the lower controls device 30 another portion of the aerial device 10, such as the upper portion 22. Further, in some embodiments, the at least one cable 32 provides bidirectional communication such that signals may be transmitted back from the upper portion 22 to the lower controls device 30.

In some embodiments, the at least one cable 32 is coupled to the side pack 26. For example, the at least one cable 32 may be routed through a back portion of the side pack storage compartment and up through the boom assembly 14 to the upper portion 22. Accordingly, the operator 28 standing on the ground proximate to the utility vehicle 12 may hold the lower controls device 30 while controlling motion or other functions of the upper portion 22. For example, the operator 28 may control motion of the boom assembly 14 and platform 20.

In some embodiments, the at least one cable 32 has a length that allows the lower controls device 30 to be pulled away from the side pack 26. For example, in some embodiments, the at least one cable 32 comprises an excess length of a foot or a few feet to allow the operator 28 to move around and traverse the ground surface within a vicinity of the utility vehicle 12, while still holding the lower controls device 30. Such an excess length of the at least one cable 32 provides mobility to the operator 28 and allows the operator 28 to move about the utility vehicle 12 while controlling the aerial device 10, for example, to gain desirable vantage of the upper portion 22.

Alternatively, or additionally, embodiments are contemplated in which the lower controls device 30 is statically mounted to the side pack 26 or another portion of the utility vehicle 12 or aerial device base. For example, in some embodiments, the lower controls device 30 is mounted to an external surface of the utility vehicle 12 such that the operator 28 does not hold the lower controls device 30 during use. However, said static mounting of the lower controls device 30 does not provide mobility and vantage to the operator 28. Accordingly, in some embodiments, one or more real-time displays such as, monitors may be disposed near the lower controls device 30 to provide a real-time visual representation of the upper portion 22.

In some embodiments, the at least one cable 32 includes one or more electrical wires, which are electrically coupled to the upper portion 22 of the aerial device 10. For example, the electrical wires may be routed to electrical components of the aerial device 10 such as any of motors, sensors, actuators, and other electrical components not explicitly described herein. Accordingly, because the electrical wires and other structures of the low voltage aerial device 10 are electrically conductive, a potential path to ground may be established through the at least one cable 32 if not for electrically insulating portions of the lower controls device 30.

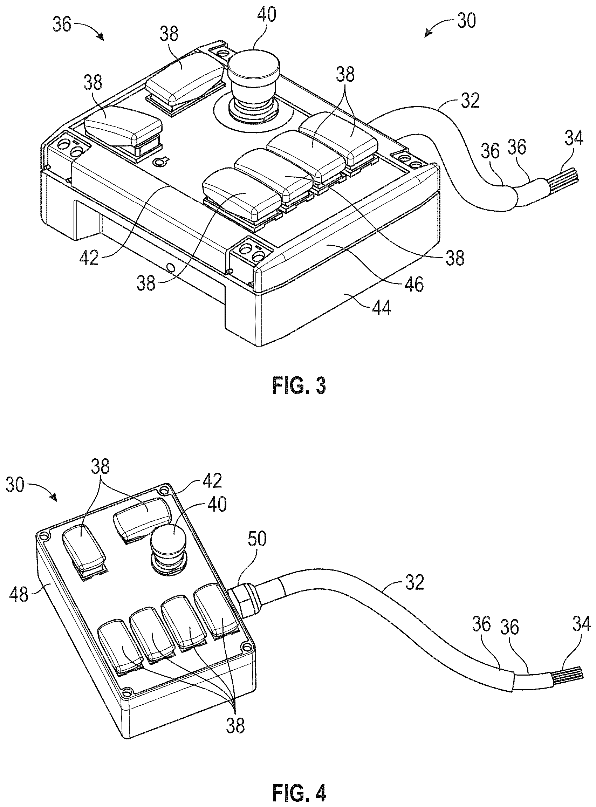

FIG. 3 illustrates an exemplary isometric view of the lower controls device 30 relating to some embodiments of the present disclosure. As described above, the lower controls device 30 may include the at least one cable 32. For example, in some embodiments, the at least one cable 32 comprises a plurality of electrical wires 34. In some embodiments, one or more insulating cable covers 36 are disposed around the plurality of electrical wires 34. In some embodiments, multiple distinct insulating cable covers are used. For example, an inner insulating cable cover may be disposed around the plurality of wires 34 and an outer insulating cable cover may be disposed external to the inner insulating cable cover to provide further electrical insulating. In some embodiments, instead of multiple distinct insulating cable covers a single insulating cable cover with a relatively greater thickness is used to provide a similar degree of electrical insulation.

In some embodiments, the lower controls device 30 comprises a plurality of user controls such as, for example, any of switches (or buttons 38) or an emergency stop control (E-stop control 40). In some embodiments, a variety of other user controls not explicitly shown are also contemplated, for example, in some embodiments, the plurality of user controls comprises any combination of switches, joysticks, and keypads, as well as other user controls and input mechanisms not explicitly described herein.

In some embodiments, each control actuator of the plurality of controls actuator has a high contact resistance at least for an external portion of the respective control actuator. For example, the switches 38 may include a high contact resistance material such as rubber, plastic, or another polymer, as well as other insulating materials not explicitly described herein. Similarly, the e-stop control 40 may include a high contact resistance portion that prevents electrical current from flowing through the e-stop control 40.

In some embodiments, the lower controls device 30 comprises an enclosure, for example, including an enclosure upper portion 42 on which, or through which the user controls may be disposed. For example, in some embodiments, the external portions of the buttons 38 and the e-stop control 40 protrude through respective openings in the enclosure upper portion 42, while a lower internal portion of the buttons/switches 38 extends vertically downward into the enclosure. The enclosure of the lower controls device 30, including the enclosure upper portion 42, comprises an electrically insulating material. For example, the enclosure may include non-conductive polymer material such as a polycarbonate or a glass-reinforced polymer. Further still, in some embodiments, the enclosure comprises other non-conductive polymer materials such as a high-density polyethylene (HDPE) or thermoplastic olefin (TPO). Further still, in some embodiments, non-conductive ceramics and composites are also contemplated for electrically insulating components of the lower controls device 30. In some embodiments, the enclosure of the lower controls device 30 encapsulates an internal portion of the lower controls device 30 to electrically isolate one or more electrical components of the lower controls device 30.

In some embodiments, the lower controls device 30 includes one or more other external coverings such as an external cover lower portion 44 and an external cover upper portion 46 disposed external to the enclosure. Similar to the enclosure, the external covering may also include a non-conductive material, such as any of the non-conductive polymers, ceramics, and composites described herein, as well as other suitable non-conductive materials not explicitly described herein.

In some embodiments, the structures described herein as including multiple separate structures and components may include a different number of components. For example, the enclosure upper portion 42 and the enclosure lower portion 48 may be combined into a single unitary enclosure structure. Similarly, in some embodiments, the external cover lower portion 44 and the external cover upper portion 46 are combined into a single unitary cover structure. However, in some embodiments, multiple separate structures affixed, for example, by fasteners are contemplated such that the internal portion of the lower controls device 30 is accessible for inspection and repair. In some embodiments, the separate structures are joined using one or more non-conductive fasteners, such as, for example, non-conductive bolts formed with polymer, or ceramic material disposed through respective fastener holes in the structures. Alternatively, or additionally, in some embodiments, other fasteners such as conductors formed of electrically conductive materials may be used. For example, the positioning of the fasteners within the lower controls device 30 such as proximate the corners of the enclosure may be separated from the internal conductive components of the lower controls device 30. Accordingly, in some embodiments, the lower controls device 30 comprises one or more conductive fasteners that do not pass through the internal portion of the lower controls device 30 or are at least a minimum threshold length away from the internal electrically conductive components such as electronics and wiring.

Turning now to FIG. 4, the lower controls device 30 is shown with the external cover portions 44 and 46 removed relating to some embodiments of the present disclosure. As mentioned above, the lower controls device 30 includes an enclosure such as a non-conductive polymer enclosure including the enclosure upper portion 42, as well as, in some embodiments, an enclosure lower portion 48, as shown, formed of a similar non-conductive material. In some embodiments, the non-conductive enclosure portions shield and electrically isolate one or more conductive components disposed in an interior of the lower controls device 30.

In some embodiments, the at least one cable 32 is coupled to the interior of the lower controls device 30 using a cable connection 50 that routes the plurality of electrical wires 34 into the interior of the lower controls device 30. In some embodiments, the cable connection 50 includes a strain relief portion that prevents tension on the at least one cable 32. Further, in some embodiments, the cable connection 50, and components thereof, are also formed of a non-conductive material that provides further electrical insulation.

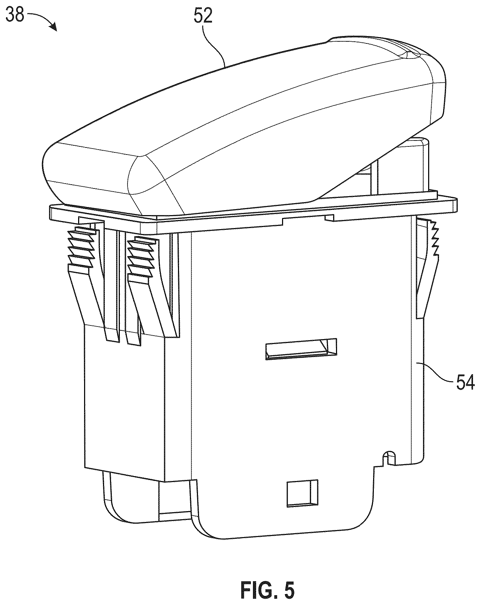

FIG. 5 illustrates an exemplary switch 38 relating to some embodiments of the present disclosure. In some embodiments, the switch or button 38 includes an external portion 52 and an internal portion 54. For example, when the switch 38 is disposed in the lower controls device 30 the external portion 52 protrudes from the enclosure while the internal portion 54 is disposed in the interior portion of the lower controls device 30.

In some embodiments, the external portion 52 comprises a non-conductive contact surface operable to receive contact actuation from the operator 28 without providing an electrical path to the operator 28. The switch 38 may include one or more non-conductive mechanical coupling components that are coupled to the external portion 52 to translate force and motion associated with the external portion 52 to the internal portion 54. Accordingly, non-conductive mechanical communication is provided between the external portion 52 to the interior of the lower controls device 30.

In some embodiments, at least one electrical component may be disposed in the internal portion 54 of the buttons 38, as will be described in further detail below. The internal portion 54 of the buttons 38 may be vertically elongated, in some embodiments, at least an inch, such that one or more electrical components of the internal portion 54 are displaced from the contact surface of the external portion 52 for further electrical isolation of said electrical components.

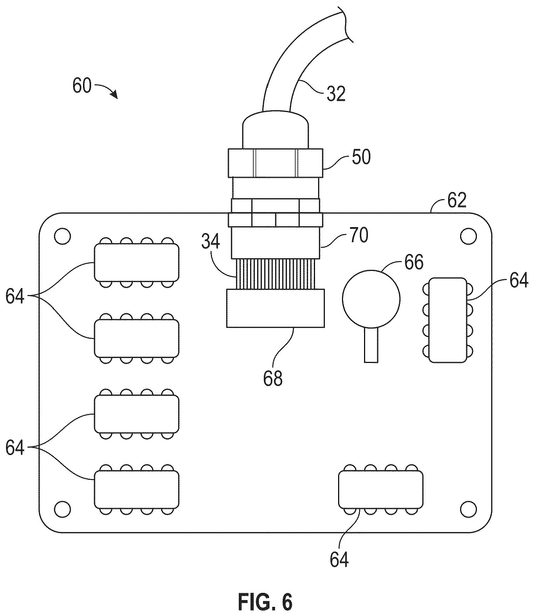

FIG. 6 illustrates an exemplary internal portion 60 of the lower controls device 30 relating to some embodiments of the present disclosure. In some embodiments, a circuit board such as a printed circuit board (PCB 62) disposed in the internal portion 60 of the lower controls device 30. For example, the PCB 62 may be coupled to a plurality of electrical components and devices of the lower controls device 30. In some embodiments, the PCB 62 comprises one or more circuit traces for transferring power and communication signals, such as control signals between the electrical components.

In some embodiments, one or more electrical chips 64 are coupled to the PCB 62. For example, in some embodiments a plurality of electrical chips 64 are disposed on the PCB 62 and coupled to one or more circuit traces of the PCB 62. In some embodiments, the electrical chip 64 comprises an integrated circuit (IC). In some embodiments, each electrical chip 64 corresponds to a respective control actuator of the lower controls device 30 such as switch 38. For example, the switch 38 may be disposed in the internal portion 54 of the buttons 38 and be coupled to one or more mechanical components of the buttons 38. Accordingly, user inputs from the operator 28 may be communicated through the buttons 38 to the respective switch 38 and into the PCB 62.

In some embodiments, an e-stop electrical portion 66 is coupled to the PCB. The e-stop electrical portion 66 may be coupled to the e-stop control 40 such that mechanical actuation of the e-stop control 40 is communicated to the e-stop electrical portion 66 and transmitted through the PCB 62 as an electrical signal. Similar to as described above with respect to the electrical chip 64, in some embodiments, the e-stop electrical portion 66 is coupled to one or more circuit traces of the PCB 62.

In some embodiments, the plurality of electrical wires 34 may be coupled to the PCB 62. For example, the electrical wires 34 may be coupled to the PCB 62 through at least one circuit board connection 68 with respective ports for each electrical wire, as shown. Accordingly, in some embodiments, input control signals from the plurality of user controls (i.e., the buttons 38 and e-stop control 40) may be transmitted by way of the PCB 62 through the at least one circuit board connection 68 and plurality of electrical wires 34. As mentioned above, in some embodiments, the plurality of electrical wires 34 provides bidirectional communication with the upper portion 22, such that, for example, a signal associated with a state of the upper portion 22 may be transmitted to the lower controls device 30. For example, in some embodiments, the lower controls device 30 may include one or more light emitting diodes (LEDs) or other indicator devices that are activated in response to a signal from the upper portion 22.

In some embodiments, an end portion 70 of the one or more insulating cable covers 36 extends into the internal portion 60 of the lower controls device 30 such as into the electrically insulating enclosure. For example, the end portion 70 may extend through the cable connection 50 to prevent exposure of the plurality of electrical wires 34 at the cable connection 50 and outside of the electrically insulating enclosure.

In some embodiments, external to the enclosure the insulating cable cover 36 covers a portion of the at least one cable 32. For example, in some embodiments, a portion of the at least one cable 32 near the lower controls device 30 may comprise the one or more insulating cable covers 36 disposed thereon, while a remaining portion, such as a portion routed up the boom assembly 14 may not include an electrically insulating cover.

In some embodiments, an overall leakage associated with the lower controls device 30 is less than approximately 3000 microamps for a predetermined voltage level. In some embodiments, at least a portion of the lower controls device 30 is configured to provide a specific level of electrical insulation at a predetermined voltage level. For example, in some embodiments, an observable electrical current leakage at 15 kV is under about 700 microamps for one or more components of the lower controls device 30 such as any of the buttons 38, the e-stop control 40, or other components such as lights and other controls. Further, embodiments are contemplated in which the electrical current leakage at 15 kV is under 1200 microamps, under 1000 microamps, or under 800 microamps for at least a portion of the lower controls device 30. Further still, in some embodiments, the electrical current leakage at a voltage of 5 kV is up to less than 3000 microamps for at least a portion of the lower controls device 30. However, it should be understood that this is just one example and that a variety of different values are also contemplated.

In some embodiments, the lower controls device 30 is rated to provide electrical insulation at a rated voltage according to qualification test voltage. For example, in some embodiments, the lower controls device 30 is rated to provide electrical insulation at a voltage of 5 kV according to a qualification test voltage of 15 kV. In some embodiments, the lower controls device 30 is rated to provide electrical insulation at a voltage of 1 kV according to a qualification test voltage of 5kV. In some embodiments, other voltage ratings and qualification test voltages not explicitly described herein are also contemplated.

In some embodiments, other solutions are contemplated to electrically isolate the lower controls and prevent an electrical path to ground. For example, embodiments are contemplated in which non-conductive wires are used in place of electrical wires to break the electrical path. Further, in some embodiments, to avoid hardwired connections, wireless or hydraulic means may be used to communicate control signals. For example, in some embodiments, the lower control device 30 may be coupled to a wireless transceiver to transmit control signals wirelessly with the upper portion 22 of the aerial device 10. In some embodiments, a radio connection such as a BLUETOOTH connection may be used to communicate control signals wirelessly, for example. As yet another alternative, embodiments are contemplated in which the lower controls are disposed on the utility vehicle 12 or on a separate platform such that the lower controls are not operated while standing on the ground. Further still, in some embodiments, a device or assembly may be included to provide an alternate path to ground that is distinct from the lower controls device 30.

Although the present disclosure has been described with reference to the embodiments illustrated in the attached drawing figures, it is noted that equivalents may be employed and substitutions made herein without departing from the scope of the present disclosure as recited in the claims.

The present disclosure also includes examples according to the following numbered clauses in which:
1. A user control device for a low voltage aerial device, the user control device disposed at a lower portion of the low voltage aerial device and comprising:
   an electrically insulating enclosure encapsulating an internal portion of the user control device;
   a plurality of user controls disposed on the electrically insulating enclosure with at least a portion of each user control of the plurality of user controls external to the electrically insulating enclosure, the plurality of user controls operable to control the low voltage aerial device from the lower portion responsive to user inputs from an operator standing on a ground surface near the lower portion;
   a plurality of electrical cables coupled to the plurality of user controls within the internal portion of the user control device, the plurality of electrical cables operable to transmit control signals associated with the plurality of user controls to an upper portion of the low voltage aerial device; and
   at least one electrically insulating cable cover disposed around the plurality of electrical cables,
   wherein the electrically insulating enclosure and the at least one electrically insulating cable cover prevent an electrical path to ground through the user control device from the upper portion of the low voltage aerial device.
2. The user control device of any preceding clause, wherein an end portion of the at least one electrically insulating cable cover extends into the electrically insulating enclosure.
3. The user control device of any preceding clause, wherein the electrically insulating enclosure and the at least one electrically insulating cable cover are rated to provide electrical insulation from a predetermined voltage level associated with an operation of the low voltage aerial device.
4. The user control device of any preceding clause, wherein the user control device is rated to provide electrical insulation at a voltage of 20 kV according to a qualification test voltage of 50 kV.
5. The user control device of any preceding clause, wherein the user control device is rated to provide electrical insulation at a voltage of 5 kV according to a qualification test voltage of 15 kV.
6. The user control device of any preceding clause, wherein the user control device is rated to provide electrical insulation at a voltage of 1 kV according to a qualification test voltage of 5 kV.
7. The user control device of any preceding clause, wherein the plurality of user controls comprises:
   one or more user input switches operable to control motion of the upper portion of the low voltage aerial device, the one or more user input switches comprising an electrically resistant contact surface; and
   an emergency stop control operable to stop operation of the low voltage aerial device, when actuated.
8. A user control device for a low voltage aerial device, the user control device disposed at a lower portion of the low voltage aerial device and comprising:
   an electrically insulating enclosure encapsulating an internal portion of the user control device;
   at least one user control disposed on the electrically insulating enclosure with at least a portion of the at least one user control external to the electrically insulating enclosure, the at least one user control operable to control the low voltage aerial device from the lower portion responsive to user inputs from an operator standing on a ground surface near the lower portion;
   at least one electrical cable coupled to the at least one user control within the internal portion of the user control device, the at least one electrical cable operable to transmit control signals associated with the at least one user control to an upper portion of the low voltage aerial device; and
   at least one electrically insulating cable cover disposed around the at least one electrical cable,
   wherein an end portion of the at least one electrically insulating cable cover extends into the electrically insulating enclosure.
9. The user control device of clause 8, wherein the at least one user control comprises a user control switch operable to control motion of the upper portion of the low voltage aerial device.
10. The user control device according to any of clauses 8 to 9, wherein the user control device is coupled to a side pack assembly of the low voltage aerial device.
11. The user control device of clause 10, wherein the at least one electrical cable comprises an excess cable length allowing the operator to traverse the ground surface proximate to the low voltage aerial device while holding the user control device.
12. The user control device according to any of clauses 8 to 11, wherein the at least one user control comprises a non-conductive external portion including an electrically resistant contact surface.
13. The user control device of clause 12, wherein the electrically insulating enclosure comprises a non-conductive polymer material.
14. The user control device according to any of clauses 8 to 13, wherein the at least one electrically insulating cable cover covers at least a portion of a length of the at least one electrical cable.
15. A lower controls system for a low voltage aerial device, the lower controls system comprising:
   a lower controls device operable to be held by an operator standing on a ground surface to control a portion of the low voltage aerial device, the lower controls device comprising:
   an electrically insulating enclosure encapsulating an internal portion of the lower controls device;
   a plurality of user controls disposed on the electrically insulating enclosure with at least a portion of each user control of the plurality of user controls external to the electrically insulating enclosure, the plurality of user controls operable to receive user inputs from the operator;
   at least one electrical cable coupled to the lower controls device, the at least one electrical cable operable to transmit control signals associated with the plurality of user controls to the low voltage aerial device; and
   at least one electrically insulating cable cover disposed around the at least one electrical cable,
   wherein the electrically insulating enclosure and the at least one electrically insulating cable cover prevent an electrical path to ground through the lower controls device.
16. The lower controls system of clause 15, wherein the electrically insulating enclosure comprises:
   a first enclosure portion; and
   a second enclosure portion.
17. The lower controls system of clause 16, wherein the at least one electrically insulating cable cover comprises:
   an internal section disposed around the at least one electrical cable; and
   an external section disposed around the internal section.
18. The lower controls system according to any of clauses 15 to 17, further comprising:
   an electrically insulating external cover disposed around the electrically insulating enclosure.
19. The lower controls system according to any of clauses 15 to 18, wherein the electrically insulating enclosure comprises a polycarbonate material.
20. The lower controls system according to any of clauses 15 to 19, wherein the electrically insulating enclosure comprises a glass-reinforced polymer material.

## Claims

1. A user control device for a low voltage aerial device, the user control device disposed at a lower portion of the low voltage aerial device and comprising:
an electrically insulating enclosure encapsulating an internal portion of the user control device;
a plurality of user controls disposed on the electrically insulating enclosure with at least a portion of each user control of the plurality of user controls external to the electrically insulating enclosure, the plurality of user controls operable to control the low voltage aerial device from the lower portion responsive to user inputs from an operator standing on a ground surface near the lower portion;
a plurality of electrical cables coupled to the plurality of user controls within the internal portion of the user control device, the plurality of electrical cables operable to transmit control signals associated with the plurality of user controls to an upper portion of the low voltage aerial device; and
at least one electrically insulating cable cover disposed around the plurality of electrical cables,
wherein the electrically insulating enclosure and the at least one electrically insulating cable cover prevent an electrical path to ground through the user control device from the upper portion of the low voltage aerial device.

2. The user control device of claim 1, wherein an end portion of the at least one electrically insulating cable cover extends into the electrically insulating enclosure.

3. The user control device of claim 1 or claim 2, wherein the electrically insulating enclosure and the at least one electrically insulating cable cover are rated to provide electrical insulation from a predetermined voltage level associated with an operation of the low voltage aerial device.

4. The user control device of any preceding claim, wherein the user control device is rated to provide electrical insulation at a voltage of 20 kV according to a qualification test voltage of 50 kV.

5. The user control device of any preceding claim, wherein the user control device is rated to provide electrical insulation at a voltage of 5 kV according to a qualification test voltage of 15 kV.

6. The user control device of any preceding claim, wherein the user control device is rated to provide electrical insulation at a voltage of 1 kV according to a qualification test voltage of 5 kV.

7. The user control device of any preceding claim, wherein the plurality of user controls comprises:
one or more user input switches operable to control motion of the upper portion of the low voltage aerial device, the one or more user input switches comprising an electrically resistant contact surface; and
an emergency stop control operable to stop operation of the low voltage aerial device, when actuated.

8. The user control device according to any of claims 1-6,
wherein the plurality of user controls comprises a user control switch operable to control motion of the upper portion of the low voltage aerial device,
wherein the user control device is coupled to a side pack assembly of the low voltage aerial device,
wherein the plurality of electrical cables comprises an excess cable length allowing the operator to traverse the ground surface proximate to the low voltage aerial device while holding the user control device.

9. The user control device according to any of claims 1-6,
wherein the plurality of user controls comprises a non-conductive external portion including an electrically resistant contact surface,
wherein the electrically insulating enclosure comprises a non-conductive polymer material,
wherein the at least one electrically insulating cable cover covers at least a portion of a length of the plurality of electrical cables.

10. A lower controls system for a low voltage aerial device, the lower controls system comprising:
a lower controls device operable to be held by an operator standing on a ground surface to control a portion of the low voltage aerial device, the lower controls device comprising:
an electrically insulating enclosure encapsulating an internal portion of the lower controls device;
a plurality of user controls disposed on the electrically insulating enclosure with at least a portion of each user control of the plurality of user controls external to the electrically insulating enclosure, the plurality of user controls operable to receive user inputs from the operator;
at least one electrical cable coupled to the lower controls device, the at least one electrical cable operable to transmit control signals associated with the plurality of user controls to the low voltage aerial device; and
at least one electrically insulating cable cover disposed around the at least one electrical cable,
wherein the electrically insulating enclosure and the at least one electrically insulating cable cover prevent an electrical path to ground through the lower controls device.

11. The lower controls system of claim 10, wherein the electrically insulating enclosure comprises:
a first enclosure portion; and
a second enclosure portion.

12. The lower controls system of claim 11, wherein the at least one electrically insulating cable cover comprises:
an internal section disposed around the at least one electrical cable; and
an external section disposed around the internal section.

13. The lower controls system of claim 10 or claim 12, further comprising:
an electrically insulating external cover disposed around the electrically insulating enclosure.

14. The lower controls system according to any of claims 10 to 13, wherein the electrically insulating enclosure comprises a polycarbonate material.

15. The lower controls system according to any of claims 10 to 14, wherein the electrically insulating enclosure comprises a glass-reinforced polymer material.
